# EUROPEAN PATENT SPECIFICATION

(11) **EP 3 942 330 B1**
(45) Date of publication and mention of the grant of the patent: **08.05.2024**
(21) Application number: 20769883.8
(22) Date of filing: 12.03.2020
(51) Int. Cl.: G01B 11/02, G01S 7/497, G01S 17/08

(54) **DISTANCE MEASUREMENT SENSOR WHICH DETECTS ERROR STATE IN ACCORDANCE WITH FOREIGN SUBSTANCE AND MOBILE ROBOT**
ABSTANDSMESSSENSOR ZUR ERFASSUNG DES FEHLERZUSTANDS GEMÄSS EINER FREMDSUBSTANZ UND MOBILER ROBOTER
CAPTEUR DE MESURE DE DISTANCE DÉTECTANT UN ÉTAT D'ERREUR EN FONCTION D'UNE SUBSTANCE ÉTRANGÈRE ET ROBOT MOBILE

(30) Priority: 12.03.2019 KR 20190028182; 12.03.2019 KR 20190028187
(43) Date of publication of application: 26.01.2022
(73) Proprietor: Yujin Robot Co., Ltd., Incheon, 22013 (KR); Miele & Cie. KG, 33332 Gütersloh (DE)
(72) Inventor: SHIN, Kyung Chul, Seoul 03010 (KR); PARK, Seong Ju, Gunpo-si Gyeonggi-do 15820 (KR); MOON, Byung Kwon, Seoul 04022 (KR); LEE, Tae Young, Bucheon-si Gyeonggi-do 14734 (KR); JEONG, Myung Kyo, Incheon 21998 (KR); LEE, Sung Bo, Incheon 21998 (KR); MUN, Chang Oh, Incheon 21632 (KR); LEE, Sang Kyu, Seoul 08107 (KR)
(74) Representative: Ellerbrächter, Dirk
(86) International application number: PCT/KR2020/003452
(87) International publication number: WO 2020/185007

(56) References cited:
- WO-A1-2015/060218
- CN-A- 106 444 746
- CN-A- 109 405 867
- JP-A- 2002 282 180
- KR-A- 20090 123 366
- KR-A- 20140 038 239
- KR-A- 20180 064 969
- KR-B1- 101 303 158
- KR-B1- 101 356 220

## Description

### TECHNICAL FIELD

A technical field of the present disclosure relates to a distance measurement sensor and a mobile robot.

### BACKGROUND ART

The contents described in this section merely provide background information on the present exemplary embodiment but do not constitute the related art.

A mobile robot or a cleaning robot performs a traveling operation or a cleaning operation in various environments. In order to allow the mobile robot or cleaning robot to recognize surrounding environments and move along a scheduled driving route, an obstacle sensing sensor which recognizes a structure such as a cliff.

A cliff environment which is mostly recognized by the robot is a shoe cabinet and a bathroom threshold. In home environments, there are various cliff environments, such as second floor railings, balconies, and terraces in high-rise buildings.

While performing the operation, when the robot cannot recognize the cliff environment as a cliff, the robot travels toward the cliff and falls from the cliff to cause damages of a main body, and also collide with other objects or people.

In contrast, while performing the operation, when the robot recognizes an environment which is not a cliff as a cliff, the robot cannot perform a normal operation, but only perform a cliff avoiding operation.

KR 101 303 158 B1 discloses a robot vacuum cleaner with a self-diagnosis mode for checking the validity of sensor outputs. In this self-diagnosis mode a sensor output is compared to a preset reference value to detect problems with the sensor.

WO 2015/060218 A1 discloses a sensor-guided dump truck with a dirt state estimating unit to detect an abnormal sensor state. The detection of abnormal sensor states is based on comparisons between deviations of sensor outputs and predetermined thresholds.

CN 109 405 867 A and CN 106 444 746 A disclose robots comprising a method of checking sensor signals.

### SUMMARY OF THE INVENTION

A main object of the exemplary embodiments of the present disclosure is to detect a foreign substance jamming phenomenon or a blocking phenomenon generated in a non-sensing area and a sensing area of the sensor by analyzing a degree of dispersion or a representative value of data varying during a detection time, to recognize an abnormal state of the sensor caused by the foreign substance located outside or inside of the distance measurement sensor.

Another object of the exemplary embodiments of the present disclosure is to quickly detect an abnormal state in which a pin of the sensor is shorted by connecting a resistor to a data line and analyzing a representative value of data varying during a detection time, to recognize an abnormal state of the sensor caused by the foreign substance located outside or inside of a distance measurement sensor.

Other and further objects of the present disclosure which are not specifically described can be further considered within the scope easily deduced from the following detailed description and the effect.

According to an aspect of the present embodiment, a distance measurement sensor includes: a light transmitter which transmits light to a target; a light receiver which receives light reflected from the target and outputs an electrical signal with a magnitude which varies in accordance with an intensity of the received light and a sensing position of the received light; and a controller which analyzes data that an electrical signal input from the light receiver over the time is changed during the detecting time to classify the state of the distance measuring sensor into a normal state and an abnormal state.

According to another aspect of the present embodiment, a mobile robot includes a distance measurement sensor which transmits and receives light between the mobile robot and a target to measure a distance to the target; and a mobile device which is implemented to move the mobile robot in response to the measured distance, and the distance measuring sensor includes: a light transmitter which transmits light to the target; a light receiver which receives light reflected from the target and outputs an electrical signal with a magnitude which varies in accordance with an intensity of the received light and a sensing position of the received light; and a controller which analyzes data that an electrical signal input from the light receiver over the time is changed during the detecting time to classify the state of the distance measuring sensor into a normal state and an abnormal state.

The controller detects an abnormal state including (i) a state in which a foreign substance is located in a non-sensing area on the light traveling path between the distance measuring sensor and the target or (ii) a state in which a front side of the distance measuring sensor is blocked, using a degree of dispersion and optionally a representative value of the data.

The controller may compare the degree of dispersion of data which is changed during the detecting time with a predetermined first threshold to detect a first error state which receives light, among states in which the foreign substance is located in the non-sensing area.

The controller may compare the representative value of the data which is changed during the detecting time with a predetermined second threshold to detect a second error state which cannot receive light, among states in which the foreign substance is located in the non-sensing area.

The controller may compare the degree of dispersion of data which is changed during the detecting time with a predetermined third threshold to detect a third error state in which the foreign substance is attached to the sensing area so that the front side of the distance measuring sensor is blocked.

The distance measuring sensor may include a pin interface including a first pin which is supplied with a power voltage, a second pin which is connected to a ground, and a third pin which outputs an electrical signal.

The light transmitter may be connected to the first pin and the second pin and the light receiver may be connected to the first pin, the second pin, and the third pin.

The controller may compare a representative value of data which is input through a data line connected to the third pin and is changed during the detection time with a predetermined first short state threshold and/or a second short state threshold to detect a state in which a part of the circuit of the distance measuring sensor is shorted.

The degree of dispersion is a value calculated based on a dispersion, a deviation, a standard deviation of data which is changed during a detection time or data from which noise is removed, or a combination thereof.

The representative value may be a value calculated based on an average value, a median value, a maximum value, a minimum value of data which is changed during a detection time or data from which noise is removed, or a combination thereof.

In accordance with a result of analyzing the degree of dispersion or the representative value, (i) when an abnormal state is repeatedly detected during a predetermined state determining time or (ii) when an abnormal state is detected within a state determination time from a timing when the distance measurement sensor is initialized, the controller may output an error message.

According to still another aspect of the present embodiment, a distance measurement sensor includes: a pin interface which includes a first pin which is supplied with a power voltage, a second pin which is connected to a ground, and a third pin which outputs an electrical signal; a light transmitter which is connected to the first pin and the second pin and transmits light; a light receiver which is connected to the first pin, the second pin and the third pin and receives the reflected light and outputs an electric signal with a magnitude varying in accordance with an intensity of the received light or a sensing position of the received light through the third pin; and a controller which analyzes data changed from an electrical signal, which is input from the third pin over the time, during the detecting time through the data line connected to the third pin to classify the state of the pin interface into the normal state and the abnormal state.

The light receiver may output an electrical signal using a position sensitive device (PSD).

The controller may include an analog to digital converter (ADC) which converts an electrical signal, which is an analog signal input through the data line, into a digital signal.

The distance measuring sensor further includes (i) a data line connected to the third pin and (ii) a resistor connected between the sensor and the ground.

The controller compares the representative value of the data which is changed during the detecting time with a first short state threshold and/or a second short state threshold to detect an abnormal state.

When the first pin and the third pin are shorted, the controller may receive an electrical signal with a value within a predetermined range with respect to the predetermined first short state threshold within the detecting time.

The first short state threshold may be set using a voltage value or a current value of data communication in a state in which the power voltage is connected to the data communication.

When the representative value is a value within a predetermined range with respect to the first short state threshold, the controller may recognize that the first pin and the third pin are shorted.

When the second pin and the third pin are shorted, the controller receives an electrical signal with a value within a predetermined range with respect to the predetermined second short state threshold within the detecting time.

The second short state threshold may be set using a voltage value or a current value of data communication in a state in which the ground is connected to the data communication.

When the representative value is a value within a predetermined range with respect to the second short state threshold, the controller may recognize that the second pin and the third pin are shorted.
(i) When an abnormal state is repeatedly detected during a predetermined state determining time or (ii) when an abnormal state is detected within a state determination time from a timing when the distance measurement sensor is initialized, the controller may output an error message.

According to another aspect of the present embodiment, a mobile robot includes a distance measurement sensor which transmits and receives light between the mobile robot and a target to measure a distance to the target; and a mobile device which is implemented to move the mobile robot in response to the measured distance, and the distance measuring sensor includes: a pin interface which includes a first pin which is supplied with a power voltage, a second pin which is connected to a ground, and a third pin which outputs an electrical signal; a light transmitter which is connected to the first pin and the second pin and transmits light; a light receiver which is connected to the first pin, the second pin and the third pin and receives the reflected light and outputs an electric signal with a magnitude varying in accordance with an intensity of the received light or a sensing position of the received light through the third pin; and a controller which analyzes data changed from an electrical signal, which is input from the third pin over the time, during the detecting time through the data line connected to the third pin to classify the state of the pin interface into the normal state and the abnormal state.

As described above, according to the exemplary embodiments of the present disclosure, it is possible to detect a non-sensing area of the sensor and a foreign substance jamming phenomenon or a blocking phenomenon generated in a sensing area by analyzing a degree of dispersion or a representative value of data varying during a detection time, to recognize an abnormal state of the sensor caused by the foreign substance located outside or inside of the distance measurement sensor.

According to the exemplary embodiments of the present disclosure, it is possible to quickly detect an abnormal state in which a pin of the sensor is shorted by connecting a resistor to a data line and analyzing a representative value of data varying during a detection time, to recognize an abnormal state of the sensor caused by the foreign substance located outside or inside of a distance measurement sensor.

Even if the effects are not explicitly mentioned here, the effects described in the following specification which are expected by the technical features of the present disclosure and their potential effects are handled as described in the specification of the present disclosure.

### BRIEF DESCRIPTION OF THE DRAWINGS

FIG. 1 is a block diagram illustrating a mobile robot according to an exemplary embodiment of the present disclosure;
FIGS. 2 and 3 are views illustrating a state of a mobile robot or a distance detecting sensor;
FIGS. 4 and 5 are block diagrams illustrating a distance detecting sensor according to another exemplary embodiments of the present disclosure;
FIG. 6 is a view illustrating a condition for detecting a state of a distance detecting sensor according to another exemplary embodiment of the present disclosure;
FIG. 7 is a circuit diagram illustrating a distance detecting sensor according to still another exemplary embodiment of the present disclosure;
FIG. 8 is a view illustrating data output by a distance detecting sensor according to still another exemplary embodiment of the present disclosure;
FIG. 9 is a flowchart illustrating an operation of checking a sensor state before starting a specific operation by a mobile robot; and
FIG. 10 is a flowchart illustrating an operation of checking a sensor state while performing a specific operation by a mobile robot.

### DETAILED DESCRIPTION OF THE EMBODIMENT

Hereinafter, in the description of the present disclosure, a detailed description of the related known functions will be omitted if it is determined that the gist of the present disclosure may be unnecessarily blurred as it is obvious to those skilled in the art and some exemplary embodiments of the present disclosure will be described in detail with reference to exemplary drawings.

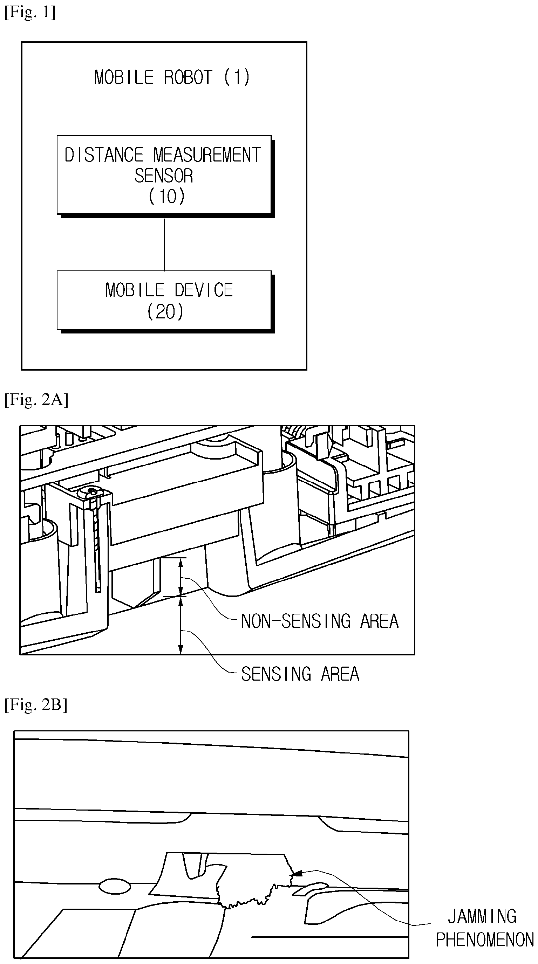

FIG. 1 is a block diagram illustrating a mobile robot according to an exemplary embodiment of the present disclosure.

As illustrated in FIG. 1, a mobile robot 1 includes a distance measurement sensor 10 and a mobile device 20. The mobile robot 1 may omit some components among various components which are exemplarily illustrated in FIG. 1 or may further include other component. For example, the mobile robot may further include a cleaning unit (not illustrated).

The moving object 1 refers to a device designed to be movable from a specific position to another position according to a predetermined method and moves from the specific position to another position using a moving unit such as wheels, rails, or walking legs. The mobile robot 1 may collect external information using a sensor and then move according to the collected information or move using a separate manipulating unit by a user.

Examples of the mobile robot 1 include robot cleaners, logistics robots, or toy cars, mobile robots for industrial or military purposes. The mobile robot 1 may travel using wheels or walk using one or more legs, or may be implemented by a combination thereof.

The robot cleaner is a device which sucks foreign materials such as dust accumulated on a floor while traveling a cleaning space to automatically clean the cleaning space. Differently from a normal cleaner which moves by an external force provided by a user, the robot cleaner cleans the cleaning space while moving using external information or a predetermined moving pattern.

The mobile robot may include a cleaning unit and a cleaning robot with a cleaning unit may include a passage which sucks dusts, a suction device, a brush, or a combination thereof.

The robot cleaner may automatically move using a predetermined pattern or detect external obstacles using a distance measurement sensor and then move as it is detected. Further, the robot cleaner may move in accordance with a signal transmitted from a remote control device which is manipulated by the user.

The distance measurement sensor may include an image sensor. The image sensor is a device which converts light entering through a lens into an electrical image signal. The image sensor may be implemented by a charge coupled device (CCD) or a complementary metal-oxide semiconductor (CMOS).

The distance measurement sensor may include a LIDAR. The LIDAR is a device which transmits a laser signal, measures a returning time of the reflected signal, and measures a distance to a reflector using a speed of light. The laser signal is converted into an electrical signal by a photo diode.

The distance measurement sensor may operate by a time of flight (TOF) manner. According to the time of flight manner, a laser emits a pulsed or square wave signal to measure a time when reflection pulses or square wave signals from objects within a measurement range reach a receiver to measure a distance between an object to be measured and a sensing sensor. The receiver may be implemented by a photo diode.

The distance measurement sensor may include a cliff recognizing sensor. One or more distance measurement sensor may be implemented on a front side, a lower portion of a rear side, or a lower end of a side of the robot.

The distance measurement sensor may transmit and receive an infrared ray to recognize a distance in accordance with a measured intensity of light. The intensity of light is compared with a reference value to determine whether it is a cliff. The distance measurement sensor transmits an infrared ray and recognizes a distance in accordance with a position of light measured in a reflective array according to a reflection angle. The distance measurement sensor may measure a distance within a sensing zone range in accordance with a ratio between a maximum width of the reflective array and a position where the received light is sensed. That is, the receiver may be implemented by a position sensitive device (PSD).

When the distance measurement sensor or the cliff recognizing sensor erroneously operates, wrong distance information is output. An erroneous operation type of the distance measurement sensor is classified into (i) a type of measuring an abnormal distance because a foreign substance is inserted into or blocks a front side through which the sensor transmits/receives light and (ii) a type of causing a cable short because a foreign substance is inserted between the sensor and a control board in the robot.

The distance measurement sensor according to the present embodiment analyzes output data of the sensor to detect an error state in which the distance measurement sensor erroneously operates, based on a degree of dispersion or a representative value of the data.

Hereinafter, a distance measurement sensor which is implemented in a mobile robot or independently operates will be described.

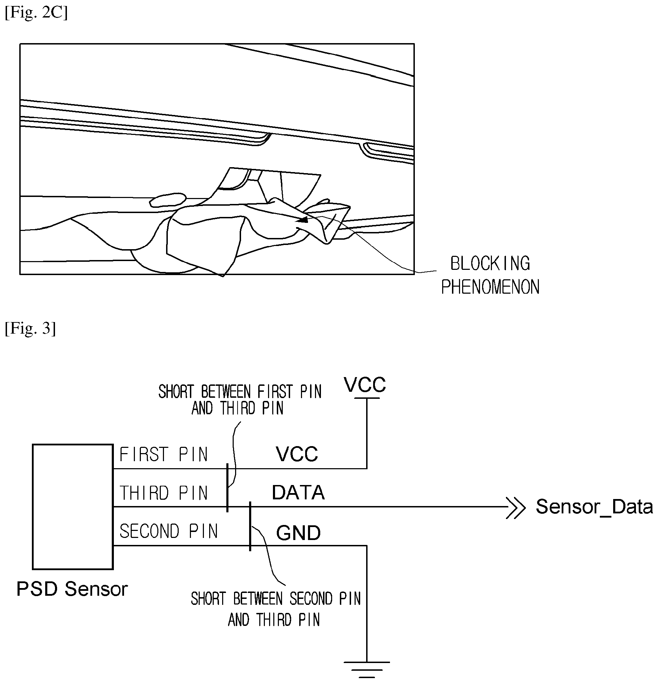

FIGS. 2 and 3 are views illustrating a state of a mobile robot or a distance detecting sensor.

The distance detecting sensor may transmit/receive light to sense a distance from minimum A to maximum B. A distance by which the distance detecting sensor transmits/receives light is classified into a sensing area and a non-sensing area. The sensing area is a distance from A to B. The non-sensing area is a distance shorter than A and is called as a dead zone. For example, the non-sensing area varies depending on a product specification and may be set to approximately 10 mm to 15 mm. When a traveling path of light transmitted and reflected by the sensor is represented by a triangle, the longer the distance, the larger the height of the triangle and the shorter the distance, the smaller the height of the triangle. The size of the reflective array is fixed in the distance detecting sensor so that the distance detecting sensor may measure a specific region in accordance with the magnitude of an incident angle of the received light. The dead zone is caused by a structural characteristic of the distance detecting sensor.

Referring to FIG. 2A, the distance detecting sensor is located in a lower portion of the mobile robot to be recessed as much as the non-sensing area. That is, a measurement reference is adjusted to measure a minimum distance of the sensing area from a bottom surface of the robot.

Due to the structural characteristic which is inwardly inserted from the lower portion of the robot, when the robot travels, a foreign substance such as tissue is inserted, as illustrated in FIG. 2B, to cause a jamming phenomenon or a tape is attached, as illustrated in FIG. 2C, to cause a blocking phenomenon. In a situation when the foreign material is inserted or the front blocking is generated, when the mobile robot or the distance detecting sensor acquires a distance, the mobile robot or the distance detecting sensor determines whether there is a cliff based on distorted distance information.

Referring to FIG. 3, a pin structure of the distance detecting sensor is illustrated. When a foreign substance is jammed between the pins of the distance detecting sensor to cause the short, the sensor is broken or a data value output by the sensor is changed. When the pin is shorted, a value of the data output by the sensor is gradually changed with a small gradient so that the robot may determine whether there is a cliff based on distorted distance information in an emergency situation, such as a state in which the robot is located to be close to the cliff.

According to the present embodiments, distance information output by the sensor is identified to be correct distance information or distorted distance information and in order to determine an abnormal state of the sensor, a degree of dispersion or a representative value of data is analyzed. According to the present embodiments, in order to quickly recognize a situation that the pin is shorted due to the foreign substance in the sensor, a resistor is added to the data line. According to the present embodiments, a situation in which a foreign substance is generated at the outside of the sensor and a situation in which a foreign substance is generated in the sensor are detected by a similar algorithm.

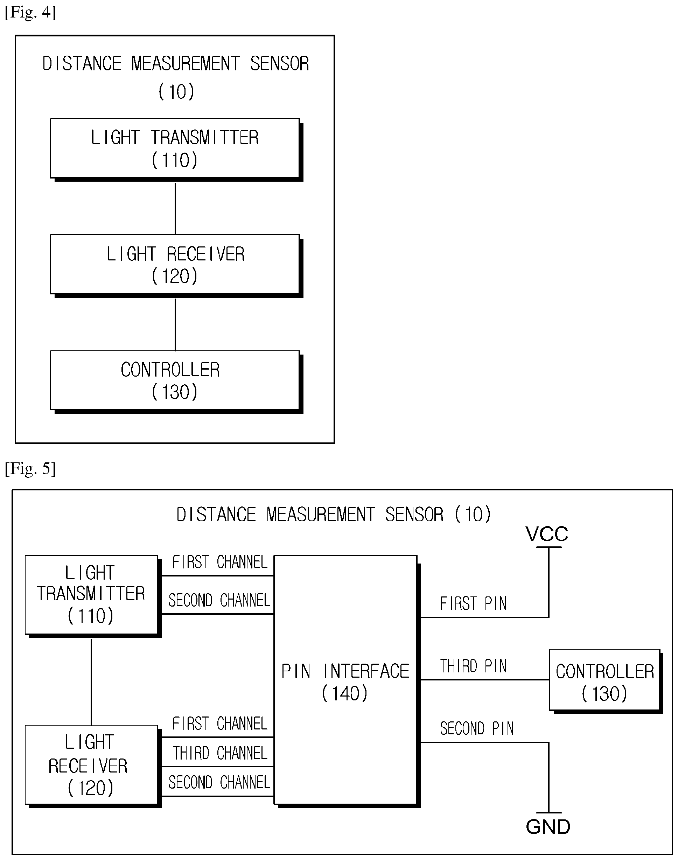

FIGS. 4 and 5 are block diagrams illustrating a distance detecting sensor according to exemplary embodiments of the present disclosure.

As illustrated in FIG. 4, the distance measurement sensor 10 includes a light transmitter 110, a light receiver 120, and a controller 103 -> 130. The distance measurement sensor 10 may omit some components among various components which are exemplarily illustrated in FIG. 5 or may further include other component. For example, the distance measurement sensor 10 may further include a pin interface 140.

The light transmitter 110 transmits light to a target. The light transmitter 110 may include a light source and a lens. The lens is located on a light traveling path. A frequency band of light emitted from the light source may be set to be a specific band, and for example, the light source may use infrared ray. The light transmitter 110 is connected to a first pin and a second pin of the pin interface 140.

The light receiver 120 receives light reflected by the target. The light transmitter 110 may include a lens. The lens is located on a light traveling path. The light receiver 120 outputs an electric signal with a magnitude which varies depending on an intensity of received light or a sensing position of the received light. The light receiver 120 may output an electrical signal using a position sensitive device (PSD). The light receiver 120 is connected to a first pin, a second pin, and a third pin of the pin interface 140.

The controller 130 analyzes data that an electrical signal input from the light receiver over the time is changed during the detection time to classify the state of the distance measurement sensor into a normal state and an abnormal state.

The controller 130 may include an analog to digital converter (ADC) which converts an electrical signal, which is an analog signal input through the data line, into a digital signal. That is, the controller 130 may process data which is a digital signal.

The pin interface 140 includes the first pin which is supplied with a power voltage, the second pin which is connected to a ground, and the third pin which outputs an electrical signal. A first channel which is connected to the first pin is connected to the light transmitter 110 and the light receiver 120. A second channel which is connected to the second pin is connected to the light transmitter 110 and the light receiver 120. A third channel which is connected to the third pin is connected to the light receiver 120. The first pin, the second pin, and the third pin included in the pin interface 140 may be formed to protrude.

The data line of the distance measurement sensor 10 is connected to the ground via the resistor so that when a cable such as the data line of the distance measurement sensor 10 is disconnected or shorted, the data is immediately changed. The distance measurement sensor further includes (i) a data line connected to the third pin and (ii) a resistor connected between the sensor and the ground.

The controller 130 receives a signal through the data line connected to the third pin. The controller 130 analyzes data which is changed from an electrical signal input from the third pin over the time during the detection time, through the data line connected to the third pin to classify the state of the pin interface into the normal state and the abnormal state.

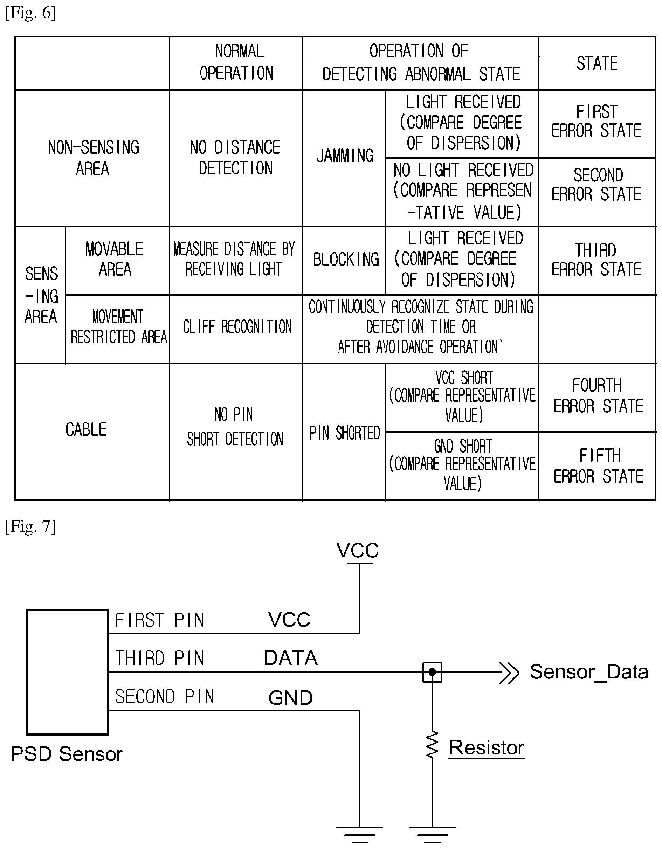

FIG. 6 is a view illustrating a condition for detecting a state of a distance detecting sensor according to exemplary embodiments of the present disclosure.

The controller detects an abnormal state including (i) a state in which a foreign substance is located in a non-sensing area on the light traveling path between the distance measurement sensor and the target or (ii) a state in which a front side of the distance measurement sensor is blocked, using the degree of dispersion or the representative value of the data.

An operation of the distance detecting sensor according to the present embodiment that detects a state in which the foreign substance is inserted may be represented by an algorithm as represented in Table 1.

**[Table 1]**

| |
|---|
| ```
Int inputPSDData_ADC = getPsdSensorData();
  Int PSD_Avg = inputPSDData_ADC.getAverage();
  Int PSD_Std = inputPSDData_ADC.getAverage();
  If ( PSD_Std < 10 )
  {
                 PSD_Sensor_Error();
  }
  else if ( PSD_Avg < 50 )
  {
                 PSD_Sensor_Error();
 }
``` |

The controller acquires data which is a digital signal and calculates a representative value of data and a degree of dispersion of the data. The representative value is a value calculated based on an average value, a median value, a maximum value, a minimum value of data which is changed during a detection time or data from which noise is removed, or a combination thereof. The degree of dispersion is a value calculated based on a dispersion, a deviation, a standard deviation of data which is changed during a detection time or data from which noise is removed, or a combination thereof. The data is represented as a voltage level or a current level.

While the robot travels, the robot consistently generates minute vibrations up and down. The degree of dispersion of a data set acquired at this time, for example, a standard deviation is larger than a predetermined value.

The controller compares the degree of dispersion of data which is changed during the detection time with a predetermined first threshold to detect a first error state which receives light, among states in which the foreign substance is located in the non-sensing area. The first error state is a state in which a foreign substance is partially inserted in the non-sensing area of the sensor and in this state, the light receiver receives light.

When the front side of the sensor is completely blocked by the foreign substance, the light receiver cannot receive reflected light. When the measured distance is farther or the light receiver does not receive light, data has a relatively low value.

The controller compares the representative value of data which is changed during the detection time with a predetermined second threshold to detect a second error state which cannot receive light, among states in which the foreign substance is located in the non-sensing area. The second error state is a state in which a foreign substance is completely inserted in the non-sensing area of the sensor and in this state, the light receiver cannot receive light.

A data result analyzed in the second error state has data similar to data measured in a state in which there is no obstacle in front of the sensor or an obstacle is located beyond the sensing area.

In order to distinguish what the cliff is normally recognized, the distance measurement sensor according to the present embodiment confirms substantially an abnormal state if a condition that the abnormal state is continuously recognized is satisfied, during a state determination time, a detection time, or after an avoiding operation.

The second threshold is a threshold regarding a representative value of the data and the first threshold is a threshold regarding a degree of dispersion of data. The second threshold may be larger than the first threshold. For example, the second threshold is set to be 50 and the first threshold is set to be 10.

An operation of the distance detecting sensor according to the present embodiment that detects a state in which a front side of the sensor is blocked may be represented by an algorithm as represented in Table 2.

**[Table 2]**

| |
|---|
| ```
  Int inputPSDData_ADC = getPsdSensorData();
  Int PSD_Avg = inputPSDData_ADC.getAverage();
  Int PSD_Std = inputPSDData_ADC.getAverage();
  If ( PSD_Std < 10 )
  {
                 PSD_Sensor_Error();
 }
``` |

The controller compares the degree of dispersion of data which is changed during the detection time with a predetermined third threshold to detect a third error state in which the foreign substance is attached to the sensing area so that the front side of the distance measurement sensor is blocked.

While the robot travels, the robot consistently generates minute vibrations up and down. The degree of dispersion of a data set acquired at this time, for example, a standard deviation is unconditionally larger than a predetermined value.

The controller may detect the state in which the front side of the sensor is blocked by the foreign substance (the third error state) by a similar manner to the state (the first error state) in which the foreign material is inserted and the light receiver receives the light.

The first threshold is a threshold regarding a degree of dispersion of data and the third threshold is a threshold regarding a degree of dispersion of data. The first threshold and the third threshold may be set to have the same value or different values. For example, the third threshold is set to be 10 and the first threshold is set to be 10.

FIG. 7 is a circuit diagram illustrating a distance detecting sensor according to exemplary embodiments of the present disclosure.

The data line of the distance measurement sensor is connected to the ground via the resistor so as to change the data immediately when the data line of the distance measurement sensor is shorted to a power voltage or to the ground.

The controller compares the representative value of the data which is changed during the detection time with a first short state threshold and/or a second short state threshold to detect an abnormal state. The controller compares the representative value of the data which is changed during the detection time with a predetermined first short state threshold and/or a predetermined second short state threshold to detect a state in which a part of a circuit of the distance measurement sensor is shorted.

In a fourth error state, the data line is shorted to the power voltage. When the first pin and the third pin are shorted, the controller receives an electrical signal with a value within a predetermined range with respect to the predetermined first short state threshold within the detection time.

The first short state threshold is set using a voltage value or a current value of data communication measured in a state in which the power voltage is connected to the data communication and the data communication is connected to the ground via the resistor. When the representative value is a value within a predetermined range with respect to the first short state threshold, the controller recognizes that the first pin and the third pin are shorted.

In a fifth error state, the data line is shorted to the ground. When the second pin and the third pin are shorted, the controller receives an electrical signal with a value within a predetermined range with respect to the predetermined second short state threshold within the detection time.

The second short state threshold is set using a voltage value or a current value of data communication measured in a state in which the ground is directly connected to the data communication and the data communication is further connected to the ground via the resistor. When the representative value is a value within a predetermined range with respect to the second short state threshold, the controller recognizes that the second pin and the third pin are shorted.

When it is assumed that the first short state threshold and the second short state threshold are set with respect to the voltage level, the first short state threshold set to be close to the power voltage is set to be larger than the second short state threshold set to be close to the ground voltage. When the first short state threshold and the second short state threshold are set with respect to a current level, the magnitude order of the first short state threshold and the second short state threshold may be set to be reverse to the order of the voltage levels.

The second threshold set with respect to the voltage level is a threshold regarding the representative value of the data and the second short state threshold is a threshold regarding the representative value of the data. The second threshold and the second short state threshold may be set to have the same or similar value. For example, the second threshold is set to be 10 and the second short state threshold is set to be 10.

A data result analyzed in the fourth error state or the fifth error state has data similar to data measured in a state in which there is no obstacle in front of the sensor or an obstacle is located beyond the sensing area.

In order to distinguish what the cliff is normally recognized, the distance measurement sensor according to the present embodiment confirms substantially an abnormal state if a condition that the abnormal state is continuously recognized is satisfied, during a state determination time, a detection time, or after an avoiding operation.

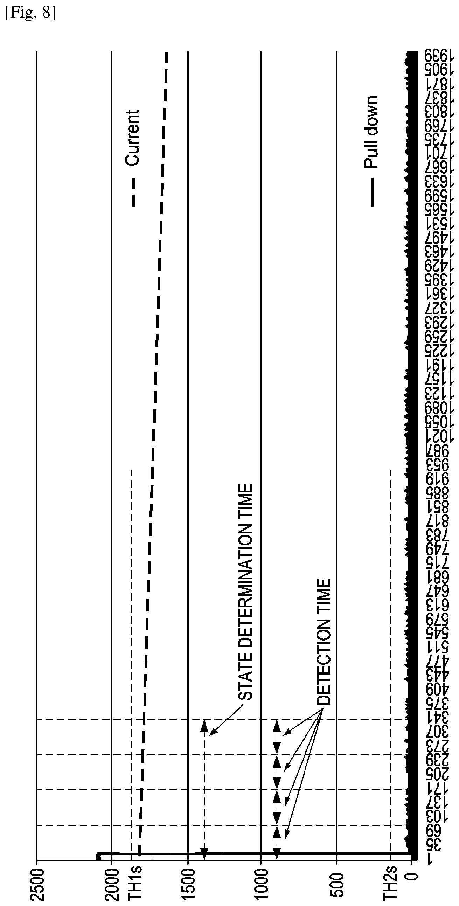

FIG. 8 is a view illustrating data output by a distance detecting sensor according to exemplary embodiments of the present disclosure. In FIG. 8, a harness is disconnected and THIs is an example of a current level of a first short state threshold and TH2s is an example of a current level of a second short state threshold.

Since the length of the detection time is directly related to the driving safety of the robot, the detection time needs to be set to have a small value. The detection time is set to be shorter than a state determination time. The controller may set to include a plurality of detection times in one state determination time.

When the resistor is not connected to the data line, in a pin-shorted state, the data changes as the current changes as illustrated in FIG. 8. A changing gradient of a signal acquired through the data line is small so that the short state cannot be detected within the detection time.

When the resistor is connected to the data line, in a pin-shorted state, the data changes as illustrated by pull down in FIG. 8. A changing gradient of a signal acquired through the data line is large so that the short state can be detected within the detection time.

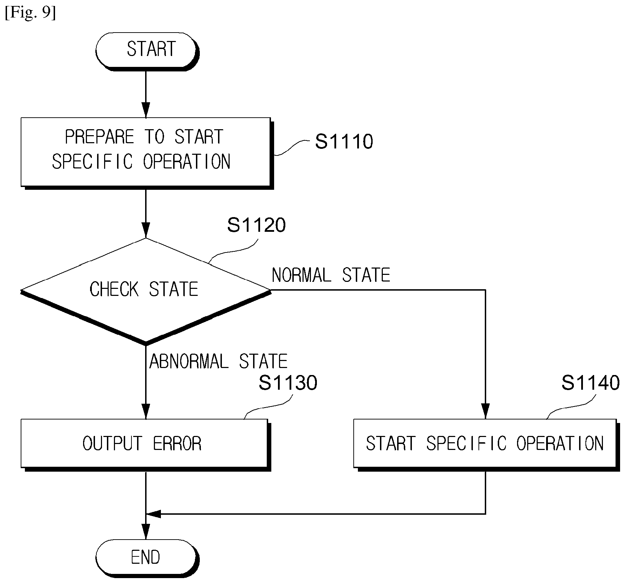

FIG. 9 is a flowchart illustrating an operation of checking a sensor state before starting a specific operation by a mobile robot.

In step S1110, a mobile robot or a distance measurement sensor prepares to start a specific operation. A stored value is read and a data setting value is initialized.

In step S 1120, the mobile robot or the distance measurement sensor checks a sensor state. The controller detects an abnormal state including (i) a state in which a foreign substance is located in a non-sensing area on the light traveling path between the distance measurement sensor and the target or (ii) a state in which a front side of the distance measurement sensor is blocked, using a degree of dispersion or a representative value of data.

In step S1130, the controller outputs an error message (i) when an abnormal state is repeatedly detected during a predetermined state determination time or (ii) when an abnormal state is detected within a state determination time from a timing when the distance measurement sensor is initialized.

In step S 1140, when the controller detects the normal state, the mobile robot or the distance measurement sensor starts a specific operation.

The mobile robot may include a cleaning unit connected to a mobile device. When the abnormal state is detected before the mobile robot (cleaning robot) starts the cleaning, the distance measurement sensor outputs an error message without starting the cleaning. When the abnormal state is detected during the cleaning by the mobile robot, the distance measurement sensor stops the cleaning operation and outputs the error message.

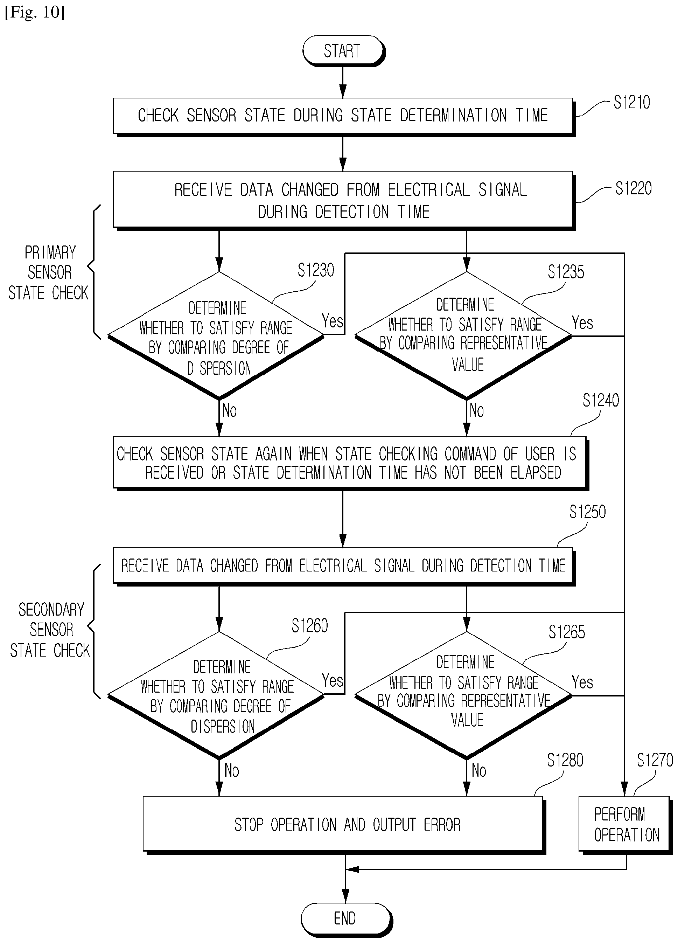

FIG. 10 is a flowchart illustrating an operation of checking a sensor state while performing a specific operation by a mobile robot.

In step S1210, the controller checks a sensor state during a state determination time. The controller may check the sensor state in two steps during the state determination time. The controller primarily checks the sensor state (S1220, S1230, and S1235).

In step S1220, the controller receives data changed from an electrical signal during the detection time. In step S1230, the controller compares the degree of dispersion and determines whether the degree of dispersion satisfies a range. In step S1235, the controller compares the representative value and determines whether the representative value satisfies the range. When the controller detects the normal state, the mobile robot or the distance measurement sensor continuously performs the operation (S 1270).

In step S1240, when the controller receives a state checking command of a user or the state determination time is not elapsed, the controller checks the sensor state again. The controller secondarily checks the sensor state (S1250, S1260, and S1265).

In step S1250, the controller receives data changed from an electrical signal during a new detection time. In step S1260, the controller compares the degree of dispersion and determines whether the degree of dispersion satisfies the range. In step S1265, the controller compares the representative value and determines whether the representative value satisfies the range. When the controller detects the normal state, the mobile robot or the distance measurement sensor continuously performs the operation (S1270).

In step S1280, in accordance with a result of analyzing the degree of dispersion or the representative value, the controller (i) repeatedly detects an abnormal state during a predetermined state determination time or (ii) outputs an error message when an abnormal state is detected within a state determination time from a timing when the distance measurement sensor is initialized.

The controller detects an abnormal state including (i) a state in which a foreign substance is located in a non-sensing area on the light traveling path between the distance measurement sensor and the target or (ii) a state in which a front side of the distance measurement sensor is blocked.
(i) When the abnormal state is repeatedly detected during the predetermined state determination time, (ii) when an abnormal state is detected within the state determination time from a timing when the mobile robot is initialized, or (iii) when the abnormal state is detected within the state determination time from a timing when the mobile robot performs a specific operation, the controller outputs the error message and stops the operation.

When the abnormal state is detected as a result of re-analyzing data changed from an electrical signal which is newly input after receiving the state checking command of the user, the controller outputs the error message again.

Even though components included in the distance measurement sensor and the mobile robot are separately illustrated in FIGS. 1, 4, and 5, the plurality of components may be coupled to each other to be implemented as at least one module. The components are connected to a communication path which connects a software module or a hardware module in the apparatus to organically operate between the components. The components communicate with each other using one or more communication buses or signal lines.

The distance measurement sensor and the mobile robot may be implemented in a logic circuit by hardware, firm ware, software, or a combination thereof or may be implemented using a general purpose or special purpose computer. The device may be implemented using hardwired device, field programmable gate array (FPGA) or application specific integrated circuit (ASIC). Further, the device may be implemented by a system on chip (SoC) including one or more processors and a controller.

The distance measurement sensor and the mobile robot may be mounted in a computing device provided with a hardware element as a software, a hardware, or a combination thereof. The computing device may refer to various devices including all or some of a communication device for communicating with various devices and wired/wireless communication networks such as a communication modem, a memory which stores data for executing programs, and a microprocessor which executes programs to perform operations and commands.

The operation according to the exemplary embodiment of the present disclosure may be implemented as a program command which may be executed by various computers to be recorded in a computer readable medium. The computer readable medium indicates an arbitrary medium which participates to provide a command to a processor for execution. The computer readable medium may include solely a program command, a data file, and a data structure or a combination thereof. For example, the computer readable medium may include a magnetic medium, an optical recording medium, and a memory. The computer program may be distributed on a networked computer system so that the computer readable code may be stored and executed in a distributed manner. Functional programs, codes, and code segments for implementing the present embodiment may be easily inferred by programmers in the art to which this embodiment belongs.

## Claims

1. A distance measurement sensor (10), comprising:
a light transmitter (110) which transmits light to a target;
a light receiver (120) which receives light reflected from the target and outputs an electrical signal with a magnitude which varies in accordance with an intensity of the received light and a sensing position of the received light; and
a controller (103)which analyzes data changed from an electrical signal which is input from the light receiver (120) over the time during a detection time to classify the state of the distance measurement sensor (10) into a normal state and an abnormal state, wherein the controller (103) detects an abnormal state including (i) a state in which a foreign substance is located in a non-sensing area on a light traveling path between the distance measurement sensor (10) and the target or (ii) a state in which a front side of the distance measurement sensor (10) is blocked, using a degree of dispersion of the data and optionally a representative value of the data,
wherein the degree of dispersion is a value calculated based on a dispersion, a deviation, a standard deviation of data which is changed during a detection time or data from which noise is removed.

2. The distance measurement sensor (10) according to claim 1, wherein the controller (103) compares the degree of dispersion of data which is changed during the detection time with a predetermined first threshold to detect a first error state which receives light, among states in which the foreign substance is located in the non-sensing area.

3. The distance measurement sensor (10) according to claim 1, wherein the controller (103) compares the representative value of data which is changed during the detection time with a predetermined second threshold to detect a second error state which cannot receive light, among the states in which the foreign substance is located in the non-sensing area.

4. The distance measurement sensor (10) according to claim 1, wherein the controller (103) compares the degree of dispersion of data which is changed during the detection time with a predetermined third threshold to detect a third error state in which the foreign substance is attached to the sensing area so that the front side of the distance measurement sensor (10) is blocked.

5. The distance measurement sensor (10) according to claim 1, wherein the distance measurement sensor (10) includes a pin interface (140) including a first pin which is supplied with a power voltage, a second pin which is connected to a ground, and a third pin which outputs the electrical signal,
the light transmitter (110) is connected to the first pin and the second pin, the light transmitter (110) is connected to the first pin, the second pin, and the third pin, and the controller (103) compares the representative value of data which is input through a data line connected to the third pin and is changed during the detection time with a predetermined first short state threshold and/or a second short state threshold to detect a state in which a part of a circuit of the distance measurement sensor (10) is shorted.

6. The distance measurement sensor (10) according to claim 5, wherein the data line of the distance measurement sensor (10) is connected to the ground via a resistor.

7. The distance measurement sensor (10) according to claim 5, wherein when the first pin and the third pin are shorted, the controller (103) receives an electrical signal with a value within a predetermined range with respect to the predetermined first short state threshold within the detection time, the first short state threshold is set using a voltage value or a current value of data communication in a state in which the power voltage is connected to the data communication, and when the representative value is a value within a predetermined range with respect to the first short state threshold, the controller (103) recognizes that the first pin and the third pin are shorted.

8. The distance measurement sensor (10) according to claim 5, wherein when the second pin and the third pin are shorted, the controller (103) receives an electrical signal with a value within a predetermined range with respect to the predetermined second short state threshold within the detection time, the second short state threshold is set using a voltage value or a current value of data communication in a state in which the ground is connected to the data communication, and when the representative value is a value within a predetermined range with respect to the second short state threshold, the controller (103) recognizes that the second pin and the third pin are shorted.

9. The distance measurement sensor (10) according to claim 1, wherein with a result of analyzing the degree of dispersion, the controller (103) outputs an error message (i) when an abnormal state is repeatedly detected during a predetermined state determination time or (ii) when an abnormal state is detected within a state determination time from a timing when the distance measurement sensor (10) is initialized.

10. A mobile robot (1), comprising:
a distance measurement sensor (10) which transmits and receives light between the mobile robot (1) and a target to measure a distance to the target; and
a mobile device (20) which is implemented to move the mobile robot (1) in response to the measured distance,
wherein the distance measurement sensor (10) includes:
a light transmitter (110) which transmits light to the target;
a light receiver (120) which receives light reflected from the target and outputs an electrical signal with a magnitude which varies in accordance with an intensity of the received light and a sensing position of the received light; and
a controller (103) which analyzes data changed from an electrical signal, which is input from the light receiver (120) over the time, during a detection time to classify the state of the distance measurement sensor (10) into a normal state and an abnormal state, wherein the controller (103) detects an abnormal state including (i) a state in which a foreign substance is located in a non-sensing area on a light traveling path between the distance measurement sensor (10) and the target or (ii) a state in which a front side of the distance measurement sensor (10) is blocked using a degree of dispersion, wherein the degree of dispersion is a value calculated based on a dispersion, a deviation, a standard deviation of data which is changed during a detection time or data from which noise is removed.

11. The mobile robot (1) according to claim 10, wherein (i) when the abnormal state is repeatedly detected during a predetermined state determination time, (ii) when an abnormal state is detected in the state determination time from a timing when the mobile robot (1) is initialized, or (iii) when the abnormal state is detected within the state determination time from a timing when the mobile robot (1) performs a specific operation, the controller (103) outputs a error message and stops the operation.

12. The mobile robot (1) according to claim 10, wherein when the abnormal state is detected as a result of re-analyzing data changed from an electrical signal, which is newly input after receiving a state checking command of a user, the controller (103) outputs the error message again.

13. The mobile robot (1) according to claim 10, further comprising:
a cleaning unit which is connected to the mobile device (20),
wherein when the abnormal state is detected before the mobile robot (1) starts cleaning, the distance measurement sensor (10) outputs an error message without starting the cleaning, and when the abnormal state is detected during the cleaning of the mobile robot (1), the distance measurement sensor (10) stops the cleaning operation and outputs the error message.

## Patentansprüche

1. Entfernungsmesssensor (10), umfassend:
einen Lichtsender (110), der Licht an ein Ziel sendet;
einen Lichtempfänger (120), der von dem Ziel reflektiertes Licht empfängt und ein elektrisches Signal mit einer Größe ausgibt, die entsprechend einer Intensität des empfangenen Lichts und einer Erfassungsposition des empfangenen Lichts variiert, und
eine Steuerung (103), die Daten analysiert, die ausgehend von einem elektrischen Signal, das von dem Lichtempfänger (120) im Lauf der Zeit während einer Erkennungszeit eingegeben wird, geändert werden, um den Zustand des Entfernungsmesssensors (10) in einen Normalzustand und einen anormalen Zustand zu klassifizieren, wobei die Steuerung (103) einen anormalen Zustand erkennt, der (i) einen Zustand, in dem sich ein Fremdkörper in einem Nichterfassungsbereich auf einem Lichtlaufweg zwischen dem Entfernungsmesssensor (10) und dem Ziel befindet, oder (ii) einen Zustand, in dem eine Vorderseite des Entfernungsmesssensors (10) blockiert ist, einschließt, unter Verwendung eines Dispersionsgrades der Daten und optional eines repräsentativen Werts der Daten,
wobei der Dispersionsgrad ein Wert ist, der basierend auf einer Dispersion, einer Abweichung, einer Standardabweichung von Daten berechnet wird, die während einer Erkennungszeit geändert werden, oder Daten, aus denen Rauschen entfernt ist.

2. Entfernungsmesssensor (10) nach Anspruch 1, wobei die Steuerung (103) den Dispersionsgrad von Daten vergleicht, die während der Erkennungszeit mit einem vorgegebenen ersten Schwellenwert geändert werden, um einen ersten Fehlerzustand zu erkennen, der Licht empfängt, unter den Zuständen, in denen sich der Fremdkörper in dem Nichterfassungsbereich befindet.

3. Entfernungsmesssensor (10) nach Anspruch 1, wobei die Steuerung (103) den repräsentativen Wert von Daten vergleicht, die während der Erkennungszeit mit einem vorgegebenen zweiten Schwellenwert geändert werden, um einen zweiten Fehlerzustand zu erkennen, der kein Licht empfangen kann, unter den Zuständen, in denen sich der Fremdkörper in dem Nichterfassungsbereich befindet.

4. Entfernungsmesssensor (10) nach Anspruch 1, wobei die Steuerung (103) den Dispersionsgrad von Daten vergleicht, die während der Erkennungszeit mit einem vorgegebenen dritten Schwellenwert geändert werden, um einen dritten Fehlerzustand zu erkennen, in dem der Fremdkörper an dem Erfassungsbereich anhaftet, sodass die Vorderseite des Entfernungsmesssensors (10) blockiert ist.

5. Entfernungsmesssensor (10) nach Anspruch 1, wobei der Entfernungsmesssensor (10) eine Stiftschnittstelle (140) einschließt, die einen ersten Stift einschließt, der mit einer Leistungsspannung versorgt wird, einen zweiten Stift, der mit einer Masse verbunden ist, und einen dritten Stift, der das elektrische Signal ausgibt,
der Lichtsender (110) mit dem ersten Stift und dem zweiten Stift verbunden ist, der Lichtsender (110) mit dem ersten Stift, dem zweiten Stift und dem dritten Stift verbunden ist, und die Steuerung (103) den repräsentativen Wert von Daten vergleicht, die durch eine mit dem dritten Stift verbundene Datenleitung eingegeben werden und während der Erkennungszeit mit einem vorgegebenen ersten Kurzschlusszustandsschwellenwert und/oder einem zweiten Kurzschlusszustandsschwellenwert geändert werden, um einen Zustand zu erfassen, in dem ein Teil einer Schaltung des Entfernungsmesssensors (10) kurzgeschlossen ist.

6. Entfernungsmesssensor (10) nach Anspruch 5, wobei die Datenleitung des Entfernungsmesssensors (10) über einen Widerstand mit der Masse verbunden ist.

7. Entfernungsmesssensor (10) nach Anspruch 5, wobei, wenn der erste Stift und der dritte Stift kurzgeschlossen sind, die Steuerung (103) ein elektrisches Signal mit einem Wert innerhalb eines vorgegebenen Bereichs in Bezug auf den vorgegebenen ersten Kurzschlusszustandsschwellenwert innerhalb der Erkennungszeit empfängt, wobei der erste Kurzschlusszustandsschwellenwert unter Verwendung eines Spannungswerts oder eines Stromwerts der Datenkommunikation in einem Zustand eingestellt wird, in dem die Leistungsspannung mit der Datenkommunikation verbunden ist, und wenn der repräsentative Wert ein Wert innerhalb eines vorgegebenen Bereichs in Bezug auf den ersten Kurzschlusszustandsschwellenwert ist, die Steuerung (103) erkennt, dass der erste Stift und der dritte Stift kurzgeschlossen sind.

8. Entfernungsmesssensor (10) nach Anspruch 5, wobei, wenn der erste Stift und der dritte Stift kurzgeschlossen sind, die Steuerung (103) ein elektrisches Signal mit einem Wert innerhalb eines vorgegebenen Bereichs in Bezug auf den vorgegebenen zweiten Kurzschlusszustandsschwellenwert innerhalb der Erkennungszeit empfängt, wobei der zweite Kurzschlusszustandsschwellenwert unter Verwendung eines Spannungswerts oder eines Stromwerts der Datenkommunikation in einem Zustand eingestellt wird, in dem die Masse mit der Datenkommunikation verbunden ist, und wenn der repräsentative Wert ein Wert innerhalb eines vorgegebenen Bereichs in Bezug auf den zweiten Kurzschlusszustandsschwellenwert ist, die Steuerung (103) erkennt, dass der zweite Stift und der dritte Stift kurzgeschlossen sind.

9. Entfernungsmesssensor (10) nach Anspruch 1, wobei die Steuerung (103) mit einem Ergebnis der Analyse des Dispersionsgrades eine Fehlermeldung (i) ausgibt, wenn ein anormaler Zustand während einer vorgegebenen Zustandsbestimmungszeit wiederholt erkannt wird oder (ii) wenn ein anormaler Zustand innerhalb einer Zustandsbestimmungszeit von einem Zeitpunkt an erkannt wird, an dem der Entfernungsmesssensor (10) initialisiert wird.

10. Mobiler Roboter (1), umfassend:
einen Entfernungsmesssensor (10), der Licht zwischen dem mobilen Roboter (1) und einem Ziel sendet und empfängt, um einen Abstand zu dem Ziel zu messen; und
eine mobile Vorrichtung (20), die implementiert ist, um den mobilen Roboter (1) als Reaktion auf den gemessenen Abstand zu bewegen,
wobei die Entfernungsmessvorrichtung (10) umfasst:
einen Lichtsender (110), der Licht an das Ziel sendet;
einen Lichtempfänger (120), der von dem Ziel reflektiertes Licht empfängt und ein elektrisches Signal mit einer Größe ausgibt, die entsprechend einer Intensität des empfangenen Lichts und einer Erfassungsposition des empfangenen Lichts variiert, und
eine Steuerung (103), die Daten analysiert, die ausgehend von einem elektrischen Signal, das von dem Lichtempfänger (120) im Lauf der Zeit während einer Erkennungszeit eingegeben wird, geändert werden, um den Zustand des Entfernungsmesssensors (10) in einen Normalzustand und einen anormalen Zustand zu klassifizieren, wobei die Steuerung (103) einen anormalen Zustand erkennt, der (i) einen Zustand, in dem sich ein Fremdkörper in einem Nichterfassungsbereich auf einem Lichtlaufweg zwischen dem Entfernungsmesssensor (10) und dem Ziel befindet, oder (ii) einen Zustand, in dem eine Vorderseite des Entfernungsmesssensors (10) blockiert ist, einschließt, unter Verwendung eines Dispersionsgrades, wobei der Dispersionsgrad ein Wert ist, der basierend auf einer Dispersion, einer Abweichung, einer Standardabweichung der Daten, die während einer Erkennungszeit berechnet werden, oder von Daten, die während einer Erkennungszeit berechnet werden, oder von Daten, von denen Rauschen entfernt ist.

11. Mobiler Roboter (1) nach Anspruch 10, wobei (i), wenn der anormale Zustand während der vorgegebenen Zustandsbestimmungszeit wiederholt erkannt wird (ii), wenn ein anormaler Zustand innerhalb der Zustandsbestimmungszeit von einem Zeitpunkt an erkannt wird, an dem der mobile Roboter (1) initialisiert wird, oder (iii), wenn der anormale Zustand innerhalb der Zustandsbestimmungszeit von einem Zeitpunkt an erkannt wird, an dem der mobile Roboter (1) einen spezifischen Vorgang durchführt, die Steuerung (103) eine Fehlermeldung ausgibt und den Vorgang stoppt.

12. Mobiler Roboter (1) nach Anspruch 10, wobei, wenn der anormale Zustand als Ergebnis der erneuten Analyse von Daten erkannt wird, die ausgehend von einem elektrischen Signal geändert werden, das nach dem Empfangen eines Zustandsprüfbefehls eines Benutzers neu eingegeben wird, die Steuerung (103) die Fehlermeldung erneut ausgibt.

13. Mobiler Roboter (1) nach Anspruch 10, ferner umfassend:
eine Reinigungseinheit, die mit der mobilen Vorrichtung (20) verbunden ist,
wobei, wenn der anormale Zustand erkannt wird, bevor der mobile Roboter (1) die Reinigung beginnt, der Entfernungsmesssensor (10) eine Fehlermeldung ausgibt, ohne die Reinigung zu starten, und wenn der anormale Zustand während der Reinigung des mobilen Roboters (1) erkannt wird, der Entfernungsmesssensor (10) den Reinigungsvorgang stoppt und die Fehlermeldung ausgibt.

## Revendications

1. Capteur de mesure de distance (10), comprenant :
un émetteur de lumière (110) qui transmet une lumière à une cible ;
un récepteur de lumière (120) qui reçoit une lumière réfléchie à partir de la cible et délivre un signal électrique avec une amplitude qui varie en fonction d'une intensité de la lumière reçue et d'une position de détection de la lumière reçue ; et
un dispositif de commande (103) qui analyse des données modifiées à partir d'un signal électrique qui est entré à partir du récepteur de lumière (120) au fil du temps pendant un temps de détection pour classifier l'état du capteur de mesure de distance (10) en un état normal et un état anormal, dans lequel le dispositif de commande (103) détecte un état anormal comportant (i) un état où une substance étrangère est située dans une zone de non-détection sur une trajectoire de lumière entre le capteur de mesure de distance (10) et la cible ou (ii) un état où un côté avant du capteur de mesure de distance (10) est bloqué, à l'aide d'un degré de dispersion des données et éventuellement d'une valeur représentative des données,
dans lequel le degré de dispersion est une valeur calculée sur la base d'une dispersion, d'un écart, d'un écart type de données qui sont modifiées pendant un temps de détection ou de données desquelles le bruit est éliminé.

2. Capteur de mesure de distance (10) selon la revendication 1, dans lequel le dispositif de commande (103) compare le degré de dispersion de données qui sont modifiées pendant le temps de détection avec un premier seuil prédéterminé pour détecter un premier état d'erreur qui reçoit une lumière, parmi des états où la substance étrangère est située dans la zone de non-détection.

3. Capteur de mesure de distance (10) selon la revendication 1, dans lequel le dispositif de commande (103) compare la valeur représentative de données qui sont modifiées pendant le temps de détection avec un deuxième seuil prédéterminé pour détecter un deuxième état d'erreur qui ne peut pas recevoir de lumière, parmi les états où la substance étrangère est située dans la zone de non-détection.

4. Capteur de mesure de distance (10) selon la revendication 1, dans lequel le dispositif de commande (103) compare le degré de dispersion de données qui sont modifiées pendant le temps de détection avec un troisième seuil prédéterminé pour détecter un troisième état d'erreur où la substance étrangère est fixée à la zone de détection de sorte que le côté avant du capteur de mesure de distance (10) est bloqué.

5. Capteur de mesure de distance (10) selon la revendication 1, dans lequel le capteur de mesure de distance (10) comporte une interface de broche (140) comportant une première broche qui est alimentée par une tension d'alimentation, une deuxième broche qui est connectée à une masse, et une troisième broche qui délivre le signal électrique,
l'émetteur de lumière (110) est connecté à la première broche et à la deuxième broche, l'émetteur de lumière (110) est connecté à la première broche, à la deuxième broche et à la troisième broche, et le dispositif de commande (103) compare la valeur représentative de données qui sont entrées par le biais d'une ligne de données connectée à la troisième broche et sont modifiées pendant le temps de détection avec un premier seuil d'état court prédéterminé et/ou un deuxième seuil d'état court pour détecter un état où une partie d'un circuit du capteur de mesure de distance (10) est court-circuitée.

6. Capteur de mesure de distance (10) selon la revendication 5, dans lequel la ligne de données du capteur de mesure de distance (10) est connectée à la masse par l'intermédiaire d'une résistance.

7. Capteur de mesure de distance (10) selon la revendication 5, dans lequel lorsque la première broche et la troisième broche sont court-circuitées, le dispositif de commande (103) reçoit un signal électrique avec une valeur dans une plage prédéterminée par rapport au premier seuil d'état court prédéterminé dans le temps de détection, le premier seuil d'état court est défini à l'aide d'une valeur de tension ou d'une valeur de courant de communication de données dans un état où la tension d'alimentation est connectée à la communication de données, et lorsque la valeur représentative est une valeur dans une plage prédéterminée par rapport au premier seuil d'état court, le dispositif de commande (103) reconnaît que la première broche et la troisième broche sont court-circuitées.

8. Capteur de mesure de distance (10) selon la revendication 5, dans lequel lorsque la deuxième broche et la troisième broche sont court-circuitées, le dispositif de commande (103) reçoit un signal électrique avec une valeur dans une plage prédéterminée par rapport au deuxième seuil d'état court prédéterminé dans le temps de détection, le deuxième seuil d'état court est défini à l'aide d'une valeur de tension ou d'une valeur de courant de communication de données dans un état où la masse est connectée à la communication de données, et lorsque la valeur représentative est une valeur dans une plage prédéterminée par rapport au deuxième seuil d'état court, le dispositif de commande (103) reconnaît que la deuxième broche et la troisième broche sont court-circuitées.

9. Capteur de mesure de distance (10) selon la revendication 1, dans lequel, avec un résultat de l'analyse du degré de dispersion, le dispositif de commande (103) délivre un message d'erreur (i) lorsqu'un état anormal est détecté de manière répétée pendant un temps de détermination d'état prédéterminé ou (ii) lorsqu'un état anormal est détecté dans un temps de détermination d'état à partir d'un moment où le capteur de mesure de distance (10) est initialisé.

10. Robot mobile (1), comprenant :
un capteur de mesure de distance (10) qui transmet et reçoit une lumière entre le robot mobile (1) et une cible pour mesurer une distance à la cible ; et
un dispositif mobile (20) qui est mis en oeuvre pour déplacer le robot mobile (1) en réponse à la distance mesurée,
dans lequel le capteur de mesure de distance (10) comporte :
un émetteur de lumière (110) qui transmet une lumière à la cible ;
un récepteur de lumière (120) qui reçoit une lumière réfléchie à partir de la cible et délivre un signal électrique avec une amplitude qui varie en fonction d'une intensité de la lumière reçue et d'une position de détection de la lumière reçue ; et
un dispositif de commande (103) qui analyse des données modifiées à partir d'un signal électrique, qui est entré à partir du récepteur de lumière (120) au fil du temps, pendant un temps de détection pour classifier l'état du capteur de mesure de distance (10) en un état normal et un état anormal, dans lequel le dispositif de commande (103) détecte un état anormal comportant (i) un état où une substance étrangère est située dans une zone de non-détection sur une trajectoire de lumière entre le capteur de mesure de distance (10) et la cible ou (ii) un état où un côté avant du capteur de mesure de distance (10) est bloqué à l'aide d'un degré de dispersion, dans lequel le degré de dispersion est une valeur calculée sur la base d'une dispersion, d'un écart, d'un écart type de données qui sont modifiées pendant un temps de détection ou de données desquelles le bruit est éliminé.

11. Robot mobile (1) selon la revendication 10, dans lequel (i) lorsque l'état anormal est détecté de manière répétée pendant un temps de détermination d'état prédéterminé, (ii) lorsqu'un état anormal est détecté dans le temps de détermination d'état à partir d'un moment où le robot mobile (1) est initialisé, ou (iii) lorsque l'état anormal est détecté dans le temps de détermination d'état à partir d'un moment où le robot mobile (1) effectue une opération spécifique, le dispositif de commande (103) délivre un message d'erreur et arrête l'opération.

12. Robot mobile (1) selon la revendication 10, dans lequel lorsque l'état anormal est détecté comme résultat de la nouvelle analyse de données modifiées à partir d'un signal électrique, qui est nouvellement entré après la réception d'une instruction de vérification d'état d'un utilisateur, le dispositif de commande (103) délivre de nouveau le message d'erreur.

13. Robot mobile (1) selon la revendication 10, comprenant en outre :
une unité de nettoyage qui est connectée au dispositif mobile (20),
dans lequel lorsque l'état anormal est détecté avant que le robot mobile (1) commence le nettoyage, le capteur de mesure de distance (10) délivre un message d'erreur sans démarrer le nettoyage, et lorsque l'état anormal est détecté pendant le nettoyage du robot mobile (1), le capteur de mesure de distance (10) arrête l'opération de nettoyage et délivre le message d'erreur.
